# EUROPEAN PATENT SPECIFICATION

(11) **EP 4 495 492 B1**
(45) Date of publication and mention of the grant of the patent: **12.11.2025**
(21) Application number: 24151436.3
(22) Date of filing: 11.01.2024
(51) Int. Cl.: F24F 1/24, F24F 1/22, F24F 1/46, F24F 11/36

(54) **AN OUTDOOR UNIT OF AIR CONDITIONER**
AUSSENEINHEIT EINER KLIMAANLAGE
UNITÉ EXTÉRIEURE DE CLIMATISEUR

(30) Priority: 18.07.2023 KR 20230093034
(43) Date of publication of application: 22.01.2025
(60) Divisional application: 25206763.2
(73) Proprietor: LG Electronics Inc., Yeongdeungpo-gu Seoul 07336 (KR)
(72) Inventor: PARK, Kiyoon, 08592 Seoul (KR); BAE, Hyunwook, 08592 Seoul (KR); LEE, Jonghae, 08592 Seoul (KR); LEE, Gwansoo, 08592 Seoul (KR); KIM, Taegyu, 08592 Seoul (KR); KIM, Hyoungjune, 08592 Seoul (KR); CHOI, Siyoung, 08592 Seoul (KR); KIM, Junhee, 08592 Seoul (KR)
(74) Representative: Vossius & Partner Patentanwälte Rechtsanwälte mbB

(56) References cited:
- WO-A1-2022/190268
- WO-A1-2023/112430
- DE-U1- 202018 006 480

## Description

The present invention relates to an outdoor unit of an air conditioner.

An air conditioner is a device that cools and heats an indoor space by heat exchange between a refrigerant flowing in a heat exchange cycle and indoor air and outdoor air.

In detail, the air conditioner includes a compressor for compressing a refrigerant, an outdoor heat exchanger for exchanging heat between the refrigerant and outdoor air, and an indoor heat exchanger for exchanging heat between the refrigerant and indoor air.

The air conditioner may include a heat storage tank. A fluid heated or cooled by a refrigerant circulating in the air conditioner may be stored in the heat storage tank. For example, the fluid may include water.

The outdoor unit of the air conditioner may include a case, the compressor accommodated inside the case, the outdoor heat exchanger, and the heat storage tank.

Meanwhile, as global environmental regulations gradually increase, conversion to ecofriendly refrigerants is required. For example, some countries are enacting related laws to use only refrigerants with a Global Warming Potential (GWP) of 100 or less within the next five years, and among refrigerants that satisfy this requirement, R290 is emerging as a highly competitive refrigerant in terms of eco-friendliness and performance.

However, the refrigerant R290 has a problem in that it is highly explosive and requires a higher level of safety design than other existing refrigerants.
(Patent Document 1) Korean Patent Publication No. 10-2022-0010865 (January 27, 2022)

Further, WO 2022 190268 A1 discloses an outdoor unit of an air conditioner comprising a casing separated inside with a barrier into a heat exchange space and an electric space, a control box connected to an inlet from the electric space space and an outlet into the heat exchange space.

An object of the present invention is to provide an outdoor unit of an air conditioner capable of blocking access of refrigerant to a control box due to refrigerant leakage.

Another object of the present invention is to provide an outdoor unit of an air conditioner having a control box capable of internal airtightness.

Another object of the present invention is to provide an outdoor unit of an air conditioner having a control box that is advantageous in dissipating heat from internal components.

Another object of the present invention is to provide an outdoor unit of an air conditioner capable of cooling components by air by forcibly flowing air without installing a fan inside a control box.

Another object of the present invention is to provide an outdoor unit of an air conditioner capable of efficiently cooling a heating component of the control box by optimizing an internal air flow path of the control box.

Another object of the present invention is to provide an outdoor unit of an air conditioner capable of maximally securing an installation space in which electric components are installed while improving heat dissipation performance.

Another object of the present invention is to provide an outdoor unit of an air conditioner capable of preventing external rainwater or condensate scattered by rotation of a fan from penetrating into a control box.

The invention is specified by the independent claim. Preferred embodiments are defined by the dependent claims.

An outdoor unit of an air conditioner according to an embodiment of the present invention includes a case forming an outside air inlet.

The outdoor unit further includes a barrier partitioning the inside of the case into a heat exchange space and an electric space.

The outdoor unit may further include a heat exchanger disposed in the heat exchange space.

The outdoor unit may further include a fan disposed in the heat exchange space.

The outdoor unit further includes a compressor disposed in the electric space.

The outdoor unit furthers include a control box assembly disposed in the electric space.

The control box assembly may include a control box connected to the outside air inlet and having electric components disposed therein.

The control box assembly may further include a heat dissipation duct connected to the inside of the control box and extending from one side of the control box to the barrier.

Air introduced through the outside air inlet may be discharged to the heat exchange space after passing through the control box and the heat dissipation duct.

The control box may include a case inlet through which air is introduced and a case outlet through which air is discharged.

The outside air inlet and the case inlet may be connected by an air pipe.

The control box may include a box case having one surface open and forming an accommodation space in which the electrical components are accommodated.

The control box may further include a box cover coupled to one open surface of the box case.

The case inlet and the case outlet may be formed in the box case.

The box case may include a lower surface portion forming a bottom surface.

The box case may further include side surface portions forming both side surfaces.

The box case may further include an upper surface portion forming an upper surface.

The box case may further include a rear surface portion forming a rear surface.

The front surface of the box case may be opened.

The rear surface portion of the box case may face the barrier.

The case inlet may be formed on a lower surface portion of the box case.

The case outlet may be formed on a rear surface portion of the box case.

The control box may further include a first PCB module installed on a rear surface portion of the box case.

The control box may further include a second PCB module spaced apart from the front surface of the first PCB module.

The first PCB module may include a high heat generating component.

The second PCB module may include a low heat generating component.

The heat dissipation duct is coupled to the rear surface portion of the box case and may be connected to the case outlet.

The heat dissipation duct may include a duct case having at least one surface open.

The heat dissipation duct may further include a duct cover coupled to one open surface of the duct case.

The duct case may include a duct outlet through which air introduced into the duct case is discharged to the outside.

The duct case may include a lower surface portion forming a bottom surface.

The duct case may further include side surface portions forming both side surfaces.

The duct case may further include a rear surface portion forming a rear surface.

The front surface and the upper surface of the duct case may be open.

The duct outlet may be formed on a rear surface portion of the duct case.

An open front surface of the duct case may be covered by a rear surface portion of the box case.

An open upper surface of the duct case may be covered by the duct cover.

The heat dissipation duct may further include a reactor module disposed inside the duct case.

The width or flow cross-sectional area of the duct case may be smaller than the width or flow cross-sectional area of the box case.

The outdoor unit may further include a heat dissipation cover connected to one side of the heat dissipation duct and guiding air passing through the heat dissipation duct to the heat exchange space.

The heat dissipation cover may include a cover outlet through which air introduced into the heat dissipation cover is discharged to the heat exchange space.

The cover outlet may be disposed at a point lower than the duct outlet.

The heat dissipation cover may include a lower surface portion forming a bottom surface.

The heat dissipation cover may further include side surface portions forming both side surfaces.

The heat dissipation cover may further include an upper surface portion forming an upper surface.

The heat dissipation cover may further include a rear surface portion forming a rear surface.

A front surface of the heat dissipation cover may be opened.

A side surface portion of the heat dissipation cover may be coupled to a side surface portion of the heat dissipation duct adjacent to a rear surface portion of the heat dissipation duct.

The cover outlet may be formed on at least one of a rear surface portion and a lower surface portion of the heat dissipation cover.

An outdoor unit of an air conditioner according to an embodiment of the present disclosure includes a case forming an outside air inlet.

The outdoor unit further includes a barrier partitioning the inside of the case into a heat exchange space and an electric space.

The outdoor unit may further include a heat exchanger disposed in the heat exchange space.

The outdoor unit may further include a fan disposed in the heat exchange space.

The outdoor unit further includes a compressor disposed in the electric space.

The outdoor unit further includes a control box assembly disposed in the electric space corresponding to an upper side of the compressor.

The control box assembly may include a control box connected to the outside air inlet through an air pipe and having electric components disposed therein.

The control box assembly may further include a heat dissipation duct connected to the inside of the control box and extending from one side of the control box to the barrier.

The control box assembly may further include a heat dissipation cover connected to an end portion of the heat dissipation duct and guiding air inside the heat dissipation duct to the heat exchange space.

The case may include a base panel forming a bottom surface of the outdoor unit.

The case may further include a front panel erected on a front end portion of the base panel.

The case may further include a side panel erected on a side surface of the base panel.

The case may further include a back cover erected on a rear end of the base panel and defining a rear surface of the electrical equipment space.

The outside air inlet may be formed in the back cover.

The control box may include a case inlet through which air is introduced.

The control box may further include a case outlet through which air is discharged.

The outside air inlet and the case inlet may be connected by the air pipe.

The case inlet may be disposed above the outside air inlet.

The case inlet may be disposed below the case outlet.

### BRIEF DESCRIPTION OF THE DRAWINGS

FIG. 1 is a front perspective view illustrating an outdoor unit of an air conditioner according to an embodiment of the present invention.
FIG. 2 is a front perspective view illustrating the outdoor unit in a state where the case is removed.
FIG. 3 is a front perspective view illustrating a control box assembly according to an embodiment of the present invention.
FIG. 4 is a front perspective view illustrating the control box assembly in a state where the box cover and the duct cover are separated.
FIG. 5 is a front perspective view illustrating the control box in a state where the second PCB module is separated.
FIG. 6 is a front view illustrating the control box in a state where the second PCB module is separated.
FIG. 7 is an exploded perspective view illustrating a state where a control box, a heat dissipation duct, and a heat dissipation cover are separated.
FIG. 8 is a front perspective view illustrating a heat dissipation duct in a state where a reactor bracket is separated.
FIG. 9 is a perspective view illustrating a control box assembly for showing an air flow path for cooling components as a whole.
FIG. 10 is a front view illustrating a control box for showing an air flow path for cooling components.

### DETAILED DESCRIPTION OF THE EMBODIMENTS

Reference will now be made in detail to the embodiments of the present invention, examples of which are illustrated in the accompanying drawings.

In the following detailed description of the preferred embodiments, reference is made to the accompanying drawings that form a part hereof, and in which is shown by way of illustration specific preferred embodiments in which the invention may be practiced. These embodiments are described in sufficient detail to enable those skilled in the art to practice the invention, and it is understood that other embodiments may be utilized and that logical structural, mechanical, electrical, and chemical changes may be made without departing from the scope of the invention. To avoid detail not necessary to enable those skilled in the art to practice the invention, the description may omit certain information known to those skilled in the art. The following detailed description is, therefore, not to be taken in a limiting sense.

Also, in the description of embodiments, terms such as first, second, A, B, (a), (b) or the like may be used herein when describing components of the present invention. Each of these terminologies is not used to define an essence, order or sequence of a corresponding component but used merely to distinguish the corresponding component from other component(s). It should be noted that if it is described in the specification that one component is "connected," "coupled" or "joined" to another component, the former may be directly "connected," "coupled," and "joined" to the latter or "connected", "coupled", and "joined" to the latter via another component.

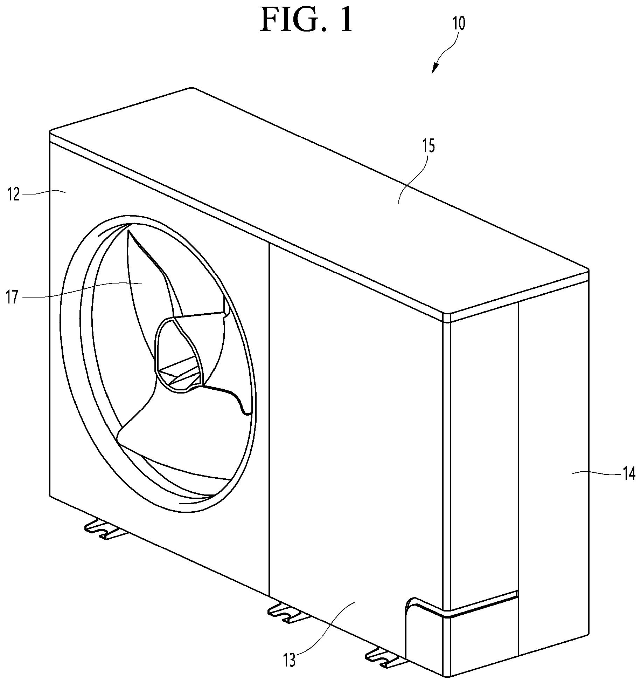

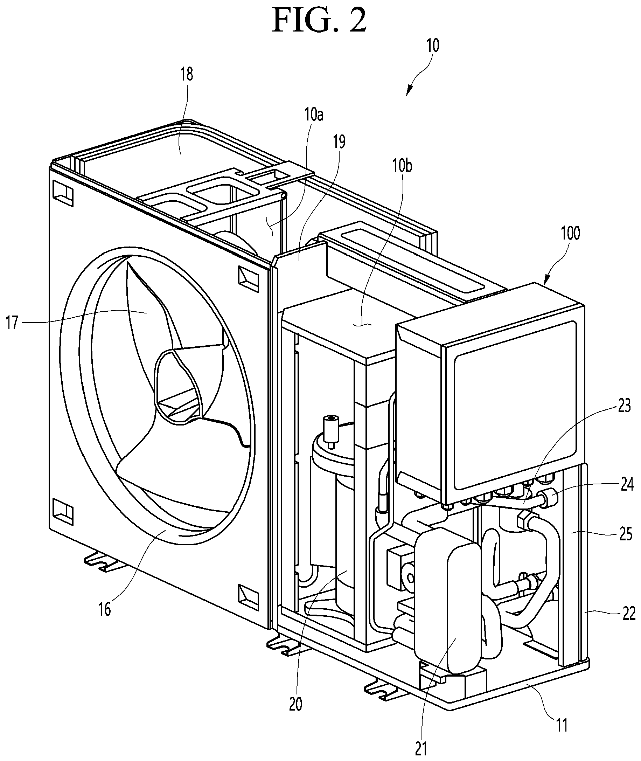

FIG. 1 is a front perspective view illustrating an outdoor unit of an air conditioner according to an embodiment of the present invention, and FIG. 2 is a front perspective view illustrating the outdoor unit in a state where the case is removed.

Referring to FIGS. 1 and 2, the outdoor unit 10 of the air conditioner according to the embodiment of the present invention includes a case forming an outer appearance of the outdoor unit.

The case may include a base panel 11 forming the bottom surface of the outdoor unit 10, a first front panel 12 erected on one side of the front end portion of the base panel 11, and a second front panel 13 erected on the other side of the front end portion.

The case may further include a side panel 14 erected on a side of the base panel 11 and a top panel 15 forming an upper surface of the outdoor unit 10.

The outdoor unit 10 may further include an orifice 16 coupled to the first front panel 12, a fan 17 placed behind the orifice 16, and a heat exchanger 18 erected on an upper surface of the base panel 11.

The outdoor unit 10 further includes a barrier 19 erected on an upper surface of the base panel 11.

The barrier 19 may partition the upper space of the base panel 11 into a left heat exchange space 10a and a right electric space 10b. The heat exchanger 18 may be disposed in the heat exchange space 10a. The heat exchanger 18 is bent and extended along the side end portion and the rear end portion of the base panel 11 to define the side surface and the rear surface of the heat exchange space 10a.

One side end portion of the first front panel 12 may be coupled to the front end portion of the heat exchanger 18 and the other side end portion may be coupled to the front end portion of the barrier 19. A rear end portion of the barrier 19 may be connected to a side end portion of the heat exchanger 18.

The outdoor unit 10 further includes a compressor 20 and a heat storage tank 21 erected on the upper surface of the base panel 11 corresponding to the electric space 10b.

The heat storage tank 21 may be disposed at a point spaced apart from the compressor 20. A flow path is provided inside the heat storage tank 21 to enable heat exchange between the refrigerant and water without mixing. A refrigerant passage and a water passage are arranged to exchange heat inside the heat storage tank 21, so that heat can be transferred from the refrigerant flowing along the refrigerant flow path to the water flowing along the water flow path.

The refrigerant passing through the compressor 20 may flow into the heat storage tank 21 along a refrigerant pipe. A water pipe unit connected to the water flow path may be connected to the heat storage tank 21.

The refrigerant passing through the heat storage tank 21 may be guided to the heat exchanger 18 along the refrigerant pipe. The refrigerant passing through the heat exchanger 18 may be guided to the heat exchanger of the indoor unit after passing through the expansion valve. The refrigerant passing through the indoor unit may be returned to the compressor 20 after passing through the gas-liquid separator.

When the fan 17 rotates, outdoor air may flow into the outdoor unit 10 through the short side portion of the heat exchanger 18 forming the side surface of the outdoor unit 10 and the long side portion of the heat exchanger 18 forming the rear surface of the outdoor unit 10.

The air that has passed through the heat exchanger 18 flows from the rear surface toward the front surface of the fan 17, passes through the orifice 16, and then is discharged to the outside of the outdoor unit 10.

A portion of the plurality of blades constituting the fan 17 may be accommodated inside the orifice 16 so that all of the air forcedly flowing by the fan 17 passes through the orifice 16.

The outdoor unit 10 may further include a control box assembly 100 accommodated in the electric space 10b. The control box assembly 100 may be disposed in an upper space of the compressor 20. The control box assembly 100 may be disposed in an upper space of the heat storage tank 21. The control box assembly 100 will be described in detail with reference to the drawings below.

The case may further include a back cover defining a rear surface of the electric space 10b. The case may further include a support panel 22 erected in front of the back cover.

An outside air inlet through which outdoor air of the outdoor unit 10 is introduced may be formed in the back cover. The outside air inlet may be formed in the back cover corresponding to the lower side of the control box assembly 100.

The support panel 22 may be coupled with a connector 24 of an air pipe 23 for guiding air introduced through the outside air inlet to the control box assembly 100.

The air pipe 23 connects the connector 24 and the control box assembly 100 so that the outside and inside of the control box assembly 100 can communicate.

The air pipe 23 may be formed of a flexible material. The air pipe 23 may connect the outside air inlet and the air inlet of the control box assembly 100.

When the fan 17 rotates, the internal pressure of the outdoor unit 10 becomes lower than the external pressure. Then, outdoor air is introduced into the outdoor unit 10 through the outdoor air inlet. Outdoor air suctioned through the outside air inlet may be discharged to the heat exchange space 10a after flowing inside the control box assembly 100 along the air pipe 23.

In this process, the heating components provided inside the control box assembly 100 can be quickly cooled by an air cooling method. The air discharged into the heat exchange space 10a may be combined with air forcedly flowing by the fan 17 and then discharged to the outside of the outdoor unit 10.

The outdoor unit 10 may further include a support bracket 25 supporting the control box assembly 100.

The support bracket 25 is erected on the upper surface of the base panel 11 and can support the lower side of the control box assembly 100. A plurality of support brackets 25 are provided to support the lower surface of the control box assembly 100, respectively.

One side of the control box assembly 100 may be coupled to the back cover, and the other side of the control box assembly 100 may be coupled to the barrier 19.

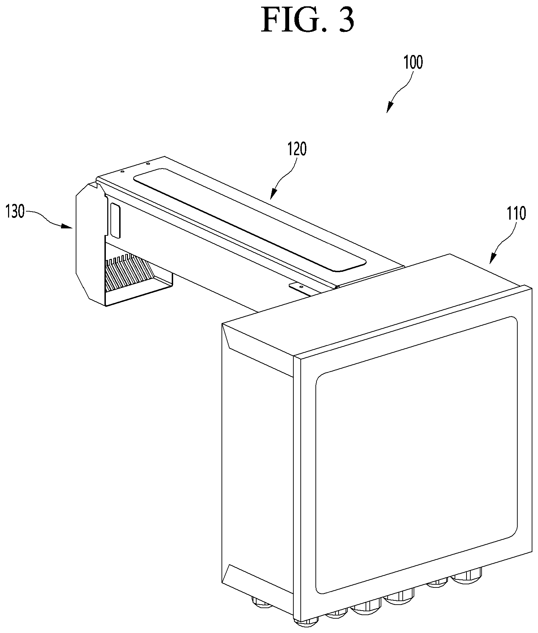

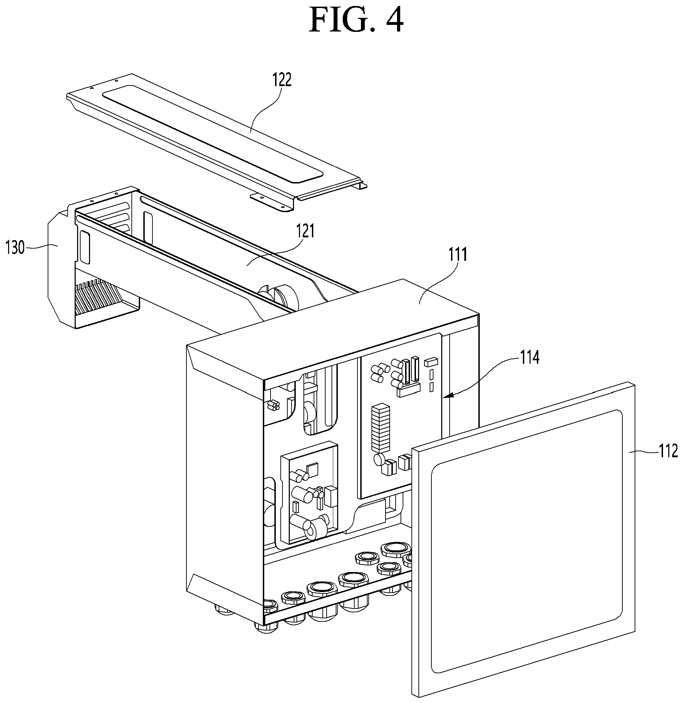

FIG. 3 is a front perspective view illustrating a control box assembly according to an embodiment of the present invention, and FIG. 4 is a front perspective view illustrating the control box assembly in a state where the box cover and the duct cover are separated.

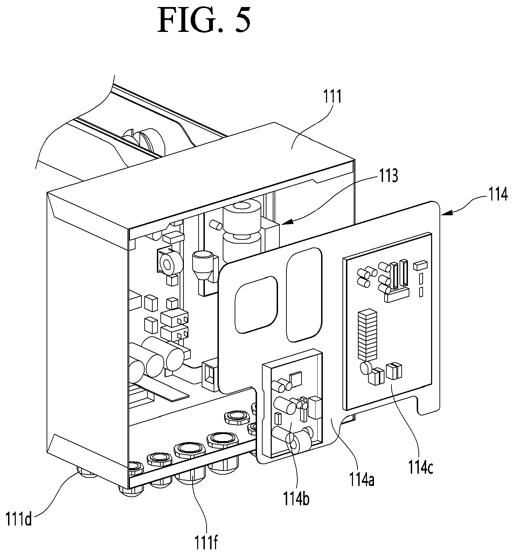

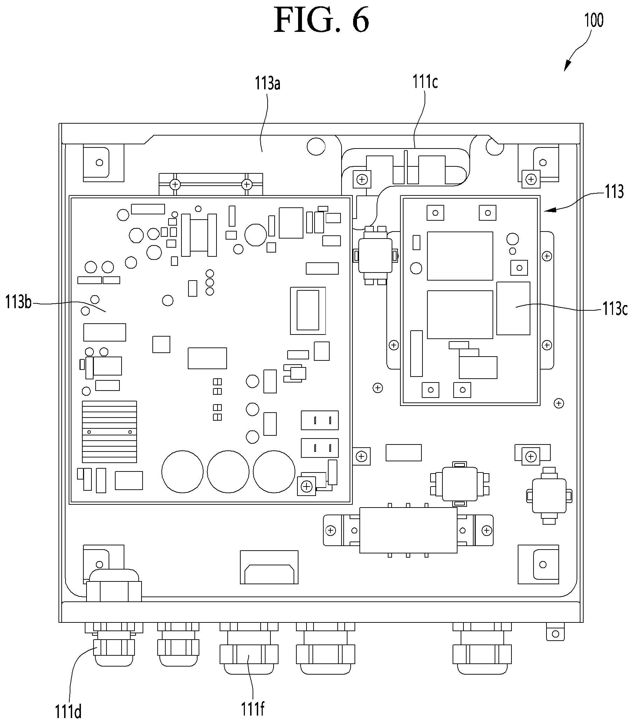

FIG. 5 is a front perspective view illustrating the control box in a state where the second PCB module is separated, and FIG. 6 is a front view illustrating the control box in a state where the second PCB module is separated.

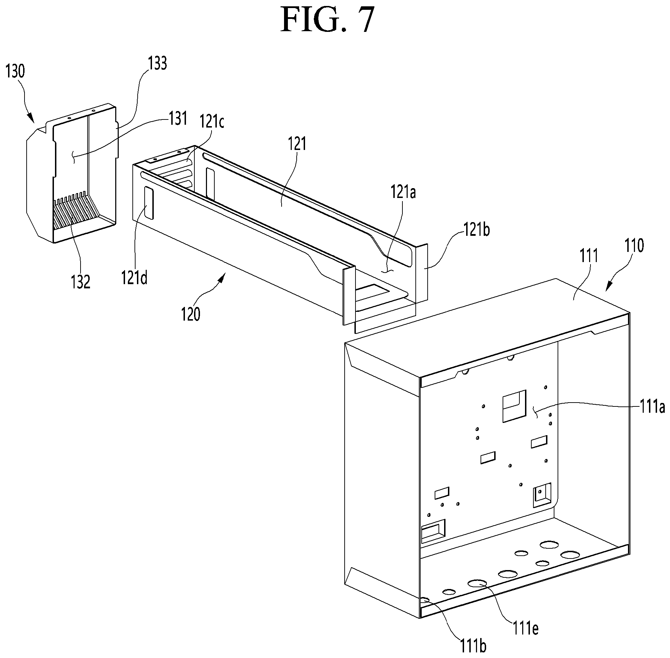

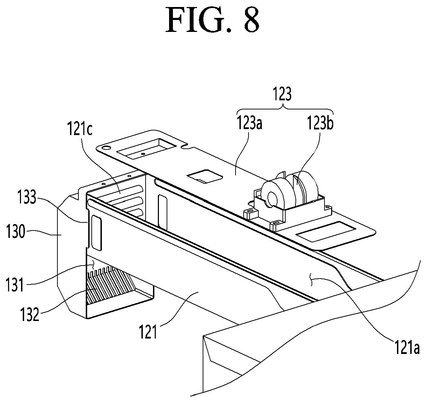

FIG. 7 is an exploded perspective view illustrating a state where a control box, a heat dissipation duct, and a heat dissipation cover are separated, and FIG. 8 is a front perspective view illustrating a heat dissipation duct in a state where a reactor bracket is separated.

Referring to FIGS. 3 to 8, the control box assembly 100 according to the embodiment of the present invention may include a control box 110. The control box assembly 100 may further include a heat dissipation duct 120. The control box assembly 100 may further include a heat dissipation cover 130.

The control box 110, the heat dissipation duct 120, and the heat dissipation cover 130 may be coupled and fixed to each other. The heat dissipation duct 120 may be disposed between the control box 110 and the heat dissipation cover 130. The control box 110 may be coupled to the front of the heat dissipation duct 120 and the heat dissipation cover 130 may be coupled to the rear of the heat dissipation duct 120.

The control box 110 may be disposed in an upper space of the heat storage tank 21.

The heat dissipation duct 120 may be disposed in an upper space of the compressor 20.

The heat dissipation cover 130 may be disposed in the heat exchange space 10a corresponding to the upper space of the fan 17.

The control box 110 may include a box case 111 accommodating electric components and a box cover 112 coupled to one side of the box case 111.

The box case 111 may have a hexahedral shape with an open front surface. An accommodation space 111a accommodating electric components may be formed inside the box case 111. However, it is not limited thereto, and the box case 111 may be formed in the shape of a polyhedron. The box case 111 may be formed of a metal material.

The box case 111 may include a lower surface portion forming a bottom surface, side surface portions forming both side surfaces, an upper surface portion forming an upper surface, and a rear surface portion forming a rear surface. The box case 111 has an open front surface, and electric components may be installed through the open front surface.

The box case 111 may include a case inlet 111b through which air suctioned through the air pipe 23 is introduced, and a case outlet 111c through which air inside the box case 111 is discharged to the outside.

The case inlet 111b may be disposed at a higher point than the outside air inlet. The case inlet 111b may be disposed at a lower point than the case outlet 111c. Accordingly, the air suctioned through the outside air inlet may move upward from the inside of the box case 111.

The case inlet 111b may be formed on a lower surface portion of the box case 111. For example, the case inlet 111b may be formed at the left edge of the lower surface portion of the box case 111.

A sealing connector 111d to which an end portion of the air pipe 23 is coupled may be provided in the case inlet 111b. The sealing connector 111d may include a rubber bush, a fastening nut, and a sealing nut, which have a sealing function. therein. After the end portion of the air pipe 23 is inserted into the sealing connector 111d, sealing between the air pipe 23 and the sealing connector 111d is possible by tightening the fastening nut and the sealing nut.

The case outlet 111c communicates with the inside of the heat dissipation duct 120. The case outlet 111c may be formed on the rear surface portion of the box case 111. For example, the case outlet 111c may be formed at the right edge of the rear surface portion of the box case 111. Accordingly, an air flow path for cooling components may be formed in an area adjacent to the rear surface portion of the box case 111.

In addition, since the case inlet 111b and the case outlet 111c are formed at one edge and the other edge of the box case 111, respectively, an air flow path for cooling components can be relatively long. Accordingly, there is an effect of improving heat dissipation performance of the heating component.

The box case 111 may further include an electric wire through-hole 111e through which an electric wire passes.

The electric wire through-hole 111e may be understood as a portion through which electric wires connected to the PCB provided inside the box case 111 can be drawn out. The electric wire through-hole 111e may be formed on a lower surface portion of the box case 111.

A sealing connector 111f to which an end portion of an electric wire is coupled may be provided in the electric wire through-hole 111e. Since the sealing connector 111f has the same configuration as the previously described sealing connector 111d, a detailed description thereof will be omitted.

The box cover 112 may be coupled to shield the open front surface of the box case 111. When the box cover 112 is coupled to the box case 111, the inside of the box case 111 may be sealed.

The control box 110 may further include a first PCB module 113 installed inside the box case 111.

The first PCB module 113 may be understood as a portion in which a heating component with relatively high heat generation is mounted. The first PCB module 113 may be installed on the rear surface portion of the box case 111.

The first PCB module 113 may include a first PCB bracket 113a, an inverter PCB 113b installed on one side of the first PCB bracket 113a, and a noise filter PCB 113c installed on the other side of the first PCB bracket 113a.

The first PCB bracket 113a may be formed in a rectangular plate shape. The first PCB bracket 113a may be erected inside the box case 111 so that a front surface of the first PCB bracket is exposed. The first PCB bracket 113a may be installed on the rear surface portion of the box case 111 so that an air flow path for cooling components passes therethrough.

Referring to FIG. 6, the inverter PCB 113b may be disposed on the front left side of the first PCB bracket 113a, and the noise filter PCB 113c may be disposed on the front right side of the first PCB bracket 113a.

The inverter PCB 113b and the noise filter PCB 113c are heating components with relatively high heat generation and may be disposed on a point adjacent to the case outlet 111c of the box case 111. The inverter PCB 113b and the noise filter PCB 113c may be disposed on a rear surface portion of the box case 111 adjacent to the case outlet 111c.

Therefore, while the air introduced through the case inlet 111b of the box case 111 flows to the case outlet 111c, the inverter PCB 113b and the noise filter PCB 113c may be intensively cooled.

The control box 110 may further include a second PCB module 114 installed inside the box case 111.

The second PCB module 114 may be understood as a portion in which a heating component with relatively low heat generation is mounted. The second PCB module 114 may be installed on a side surface portion or an upper surface portion of the box case 111.

The second PCB module 114 may include a second PCB bracket 114a, a sub-PCB 114b installed on one side of the second PCB bracket 114a, and a main PCB 114c installed on the other side of the second PCB bracket 114a.

The second PCB bracket 114a may be formed in a rectangular plate shape. The second PCB bracket 114a may be spaced apart from the front of the first PCB bracket 113a. The second PCB bracket 114a may be formed to have an area smaller than that of the first PCB bracket 114a.

The second PCB bracket 114a may be disposed adjacent to the open front surface portion of the box case 111, that is, the box cover 112. The second PCB bracket 114a may be erected inside the box case 111 so that the front surface of the second PCB bracket is exposed.

The sub PCB 114b may be disposed on the left front side of the second PCB bracket 114a, and the main PCB 114c may be disposed on the right front side of the second PCB bracket 114a.

The sub-PCB 114b and the main PCB 114c are heating components with relatively low heat generation and may be disposed at a position spaced apart from the case outlet 111c of the box case 111. The sub PCB 114b and the main PCB 114c may be disposed on the side of the box cover 112 spaced forward from the case outlet 111c.

In summary, the first PCB module 113, in which a heating component with relatively high heat generation is mounted, is disposed adjacent to a side of the rear surface portion of the box case 111 where an air flow path for cooling the component is formed, and thus there is an effect that cooling of the high heating component can be made intensively.

In addition, the second PCB module 114, in which a heating component with relatively low heat generation is mounted, is disposed adjacent to a side of the box cover 112 spaced apart from the air flow path for cooling the component, and thus there is an effect of securing an installation space for installing components.

The heat dissipation duct 120 is connected to the control box 110 and serves as a passage for guiding the air discharged through the case outlet 111c of the control box 110 to the heat exchange space 10a. The heat dissipation duct 120 may have a front end portion connected to the rear surface portion of the control box 110 and a rear end portion connected to the barrier 19. That is, the heat dissipation duct 120 may be formed to extend from the rear surface portion of the control box 110 to the barrier 19.

The heat dissipation duct 120 may include a duct case 121 accommodating electric components and a duct cover 122 coupled to one side of the duct case 121.

The duct case 121 may have a hexahedral shape with open front and top surfaces. An accommodation space 121a for accommodating electric components may be formed inside the duct case 121. The duct case 121 is formed long in the front and rear direction, so that the front end portion may be coupled to the rear surface portion of the control box 110 and the rear end portion may be coupled to the barrier 19. However, it is not limited thereto, and the duct case 121 may be formed in the shape of a polyhedron. The duct case 121 may be formed of a metal material.

The duct case 121 may include a lower surface portion forming a bottom surface, a side surface portion forming both side surfaces, and a rear surface portion forming a rear surface. The front and upper surfaces of the duct case 121 are open, and electric components may be installed through the open front and upper surfaces.

The duct case 121 may include a case coupling portion 121b to be coupled with the control box 110.

The case coupling portion 121b may be understood as a portion for welding the duct case 121 to the box case 111. The case coupling portion 121b may be formed by bending the front end portion of the duct case 121 outward. The case coupling portion 121b may extend outward along the front edge of the duct case 121 and come into close contact with the rear surface portion of the box case 111.

When the duct case 121 is coupled to the rear surface portion of the box case 111, the open front surface of the duct case 121 and the case outlet 111c of the box case 111 may be connected. Accordingly, the air flowing inside the box case 111 may flow into the duct case 121 through the case outlet 111c.

The duct case 121 may further include a duct outlet 121c for discharging internal air of the duct case 121 to the outside.

The duct outlet 121c may be formed on a rear surface portion of the duct case 121. The duct outlet 121c may be formed in the form of a plurality of discharge grilles. The duct outlet 121c may be connected to the heat exchange space 10a of the outdoor unit 10 where the fan 17 is disposed. Accordingly, the air flowing inside the duct case 121 may be quickly introduced into the suction side of the fan 17 through the duct outlet 121c.

The duct case 121 may further include a cover coupling portion 121d to be coupled with the heat dissipation cover 130.

The cover coupling portion 121d may be understood as a portion where the duct case 121 and the heat dissipation cover 130 are fastened by a fastening member. The cover coupling portion 121d may be formed on both side surfaces of the duct case 121, respectively. The cover coupling portion 121d is formed on both side surfaces adjacent to the rear end portion of the duct case 121, respectively, so that coupling with the heat dissipation cover 130 may be facilitated.

The duct cover 122 may be coupled to shield the open upper surface of the duct case 121. When the duct case 121 is coupled to the rear surface portion of the box case 111 and the duct cover 122 is coupled to the duct case 121, the inside of the duct case 121 may be sealed.

The heat dissipation duct 120 may further include a reactor module 123 installed inside the duct case 121.

The reactor module 123 may include a reactor bracket 123a and a reactor 123b installed in the reactor bracket 123a.

The reactor bracket 123a may be formed in a rectangular plate shape. The reactor bracket 123a may be formed long in the front and rear direction corresponding to the shape of the duct case 121. The reactor bracket 123a may be formed of a metal material.

The reactor bracket 123a may be seated and supported on the bottom surface of the duct case 121. The reactor bracket 123a may be welded and fixed to the bottom surface of the duct case 121.

The reactor 123b may be understood as an electronic device that stores electromagnetic energy and exhibits a large inductive reactance with respect to a rapid change in current.

The reactor 123b may be installed on an upper surface of the reactor bracket 123a. The reactor 123 may be fastened to the reactor bracket 123a by a fastening member.

The reactor 123b belongs to a heating component with relatively high heat generation. Therefore, by disposing the reactor 123b inside the duct case 121, the reactor 123b can be cooled by an air cooling method.

In addition, the left-right width or air flow cross-sectional area of the duct case 121 may be smaller than the left-right width or air flow cross-sectional area of the box case 111. Accordingly, the flow cross-sectional area of the air flow path for cooling the component gradually decreases, so that the flow rate of air can be increased. If the flow rate of air increases, cooling of the reactor 123b may be performed more quickly.

The heat dissipation cover 130 is connected to the heat dissipation duct 120 and guides the air discharged through the duct outlet 121c of the heat dissipation duct 110 to the heat exchange space 10a.

In addition, the heat dissipation cover 130 covers the duct outlet 121c of the heat dissipation duct 120, and serves to prevent moisture and foreign substances from entering from the outside.

The heat dissipation cover 130 may be coupled to the rear surface portion of the heat dissipation duct 120. The heat dissipation cover 130 may be coupled to both side surfaces and the rear surface of the duct case 121 to cover the duct outlet 121c of the duct case 121.

In detail, the heat dissipation cover 130 may be formed in the shape of a polyhedron with an open front surface. The heat dissipation cover 130 may be formed to be long in the vertical direction and may cover the duct outlet 121c of the duct case 121.

The heat dissipation cover 130 may be disposed in the heat exchange space 10a of the outdoor unit 10. The heat dissipation cover 130 may be disposed above or on the side of the fan 17 disposed in the heat exchange space 10a. A flow space 131 through which air flows may be formed inside the heat dissipation cover 130.

The heat dissipation cover 130 may include a lower surface portion forming a bottom surface, a side surface portion forming both side surfaces, an upper surface portion forming an upper surface, and a rear surface portion forming a rear surface. The heat dissipation cover 130 has an open front surface, and at least a portion of the open front surface may face the duct outlet 121c of the duct case 121. Accordingly, the inside of the heat dissipation cover 130 and the inside of the duct case 121 may be in communication with each other.

At least one of the upper surface portion, rear surface portion, and lower surface portion of the heat dissipation cover 130 may be formed stepwise to have a gradient shape. Therefore, there is an effect of preventing rainwater from outside from penetrating into the heat dissipation duct 120 or condensed water scattered by rotation of the fan 17 from penetrating into the heat dissipation duct 120.

The heat dissipation cover 130 may include a cover outlet 132 through which internal air of the heat dissipation cover 130 is discharged to the outside (a heat exchange space).

The cover outlet 132 may be formed on at least one of a rear surface portion and a lower surface portion of the heat dissipation cover 130. However, to prevent water introduced from the outside through the cover outlet 132 from penetrating into the heat dissipation duct 120 through the duct outlet 121c, the cover outlet 132 may be placed at a lower point than the duct outlet 121c.

With this configuration, the air discharged through the duct outlet 121c may be bent downward inside the heat dissipation cover 130 and then discharged to the heat exchange space 10a through the cover outlet 132.

In addition, since the duct outlet 121c is covered by the heat dissipation cover 130 and the cover outlet 132 is disposed at a lower point than the duct outlet 121c, permeation of water through the cover outlet 132 may be prevented in advance.

The heat dissipation cover 130 may further include a duct coupling portion 133 coupled to the heat dissipation duct 120.

The duct coupling portion 133 may be understood as a portion where the heat dissipation cover 130 and the heat dissipation duct 120 are fastened by a fastening member. The duct coupling portion 133 may be formed on both side surfaces of the heat dissipation cover 130, respectively. The duct coupling portion 133 is formed on both side surfaces adjacent to the front end portion of the heat dissipation cover 130, so that coupling with the heat dissipation duct 120 can be facilitated.

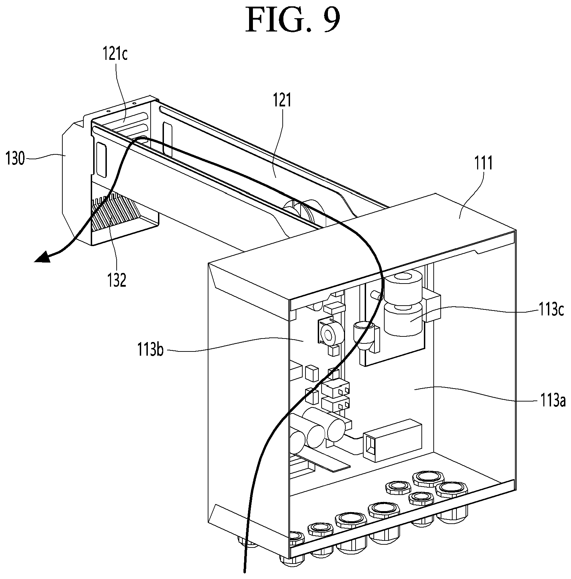

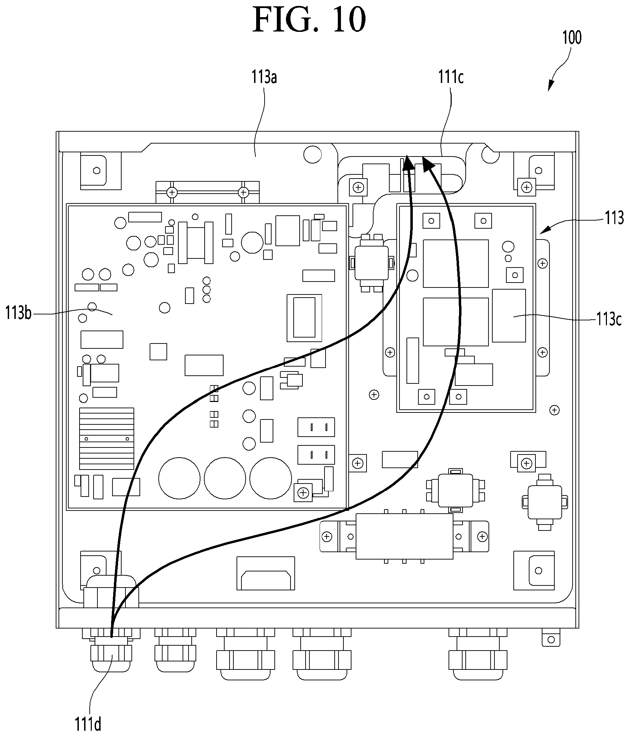

FIG. 9 is a perspective view illustrating a control box assembly for showing an air flow path for cooling components as a whole, and FIG. 10 is a front view illustrating a control box for showing an air flow path for cooling components.

Referring to FIGS. 2, 9, and 10 together, when the outdoor unit 10 according to the embodiment of the present invention operates, the compressor 20 and the fan 17 operate.

By driving the fan 17, the internal pressure of the outdoor unit 10 becomes lower than the external pressure. Then, outdoor air is introduced into the air pipe 23 through the outside air inlet. The air introduced into the air pipe 23 passes through the inside of the control box 110 through the case inlet 111b and then is discharged through the case outlet 111c.

In this process, the heating components disposed inside the control box 110 can be quickly cooled by an air cooling method. In particular, since the first PCB module 113 in which the high heating component is disposed is disposed adjacent to the case inlet 111b and the case outlet 111c, heat dissipation performance of the heating component may be improved.

In addition, the case inlet 111b and the case outlet 111c are formed at one corner portion and the other corner portion facing diagonally from one corner portion based on the rear surface portion of the box case 111, respectively, and thus the cooling flow path may be formed as long as possible.

Air discharged through the case outlet 111c is introduced into the heat dissipation duct 120 and then discharged to the outside through the duct outlet 121c. In this process, the reactor 123b disposed inside the heat dissipation duct 120 may be cooled by an air cooling method.

In particular, since the left-right width or the air flow cross-sectional area of the duct case 121 is smaller than the left-right width or the air flow cross-sectional area of the box case 111, the flow cross-sectional area of the air flow path is narrowed and the air flow rate can be increased. If the air flow rate increases, cooling of the reactor 123b may be performed more quickly.

Air discharged through the duct outlet 121c is introduced into the heat dissipation cover 130 and then discharged to the heat exchange space 10a through the cover outlet 132. The air discharged into the heat exchange space 10a is combined with air forcedly flowing by the fan 17 and then discharged to the outside (front) of the outdoor unit 10.

According to the outdoor unit of the air conditioner according to the embodiment of the present invention having the above structure, the following effects are obtained.

First, since the inside of the control box is made of a sealed structure, there is an effect of blocking access of refrigerant to the control box due to refrigerant leakage.

Second, since the air suctioned in through the outside air inlet passes through the inside of the control box and is discharged to the fan side, there is an effect of quickly cooling the heating component by the air cooling method.

In particular, as the case inlet and case outlet of the control box are spaced as far apart as possible, an air flow path for cooling components may be relatively long. Accordingly, heat dissipation performance of the heating component may be improved.

In addition, since the width or flow cross-sectional area of the heat dissipation duct is smaller than the width or flow cross-sectional area of the control box, the flow rate of air increases, so that cooling can be performed more quickly.

Third, inside the control box, the high-heating components are placed adjacent to the case outlet and the low-heating components are placed relatively apart from the case outlet, and thus there is an effect that the heating components can be efficiently cooled and the space for installing the portions can be secured.

Fourth, since the heat dissipation cover is provided at the end portion of the heat dissipation duct, there is an effect of preventing external rainwater or condensate scattered by rotation of the fan from penetrating into the control box.

Fifth, since a cooling flow path can be formed by forcibly flowing air due to a pressure difference without installing a separate fan inside the control box, there is an effect of reducing the unit cost of the component.

## Claims

1. An outdoor unit (10) of an air conditioner comprising:
a case forming an outside air inlet;
a barrier (19) partitioning an inside of the case into a heat exchange space (10a) and an electric space (10b);
a compressor (20) disposed in the electric space (10b); and
a control box assembly (100) disposed in the electric space (10b),
wherein the control box assembly (100) includes:
a control box (110) connected to the outside air inlet and having electric components disposed therein; and
a heat dissipation duct (120) connected to an inside of the control box (110) and extending from one side of the control box (110) to the barrier (19), and
wherein the air introduced through the outside air inlet is discharged to the heat exchange space (10a) after passing through the control box (110) and the heat dissipation duct (120).

2. The outdoor unit of an air conditioner of claim 1, wherein the control box (110) includes:
a case inlet (111b) through which air is introduced; and
a case outlet (111c) through which air is discharged, and
wherein the outside air inlet and the case inlet (111b) are connected by an air pipe (23).

3. The outdoor unit of an air conditioner of claim 2, wherein the control box (110) includes:
a box case (111) having an open surface and forming an accommodation space in which the electrical components are accommodated; and
a box cover (112) coupled to the open surface of the box case (111), and
wherein the case inlet (111b) and the case outlet (111c) are formed in the box case (111).

4. The outdoor unit of an air conditioner of claim 3, wherein the box case (111) includes:
a lower surface portion forming a bottom surface;
side surface portions forming both side surfaces;
an upper surface portion forming an upper surface; and
a rear surface portion forming a rear surface, and
wherein the front surface of the box case (111) is open, and the rear surface portion of the box case (111) faces the barrier (19).

5. The outdoor unit of an air conditioner of claim 4,
wherein the case inlet (111b) is formed on the lower surface portion of the box case (111), and
wherein the case outlet (111c) is formed on the rear surface portion of the box case (111).

6. The outdoor unit of an air conditioner of claim 4 or 5, wherein the control box (110) further includes:
a first PCB module (113) installed on the rear surface portion of the box case (111); and
a second PCB module (114) spaced apart from the front of the first PCB module (113),
wherein the first PCB module (113) includes a high heat generating component, and
wherein the second PCB module (114) includes a low heat generating component.

7. The outdoor unit of an air conditioner of any one of claims 4 to 6, wherein the heat dissipation duct (120) is coupled to the rear surface portion of the box case (111) and is connected to the case outlet (111c).

8. The outdoor unit of an air conditioner of any one of claims 1 to 7, wherein the heat dissipation duct (120) includes:
a duct case (121) in which at least one surface is open; and
a duct cover (122) coupled to the open surface of the duct case (121), and
wherein the duct case (121) includes a duct outlet (121c) through which air introduced into the duct case (121) is discharged to the outside.

9. The outdoor unit of an air conditioner of claim 8, wherein the duct case (121) includes:
a lower surface portion forming the bottom surface;
side surface portions forming both side surfaces; and
a rear surface portion forming a rear surface,
wherein a front surface and an upper surface of the duct case (121) are open, and
wherein the duct outlet (121c) is formed on a rear surface portion of the duct case (121).

10. The outdoor unit of an air conditioner of claim 9,
wherein the open front surface of the duct case (121) is covered by the rear surface portion of the box case (111), and
wherein the open upper surface of the duct case (121) is covered by the duct cover (122).

11. The outdoor unit of an air conditioner of any one of claims 8 to 10, wherein the heat dissipation duct (120) further includes a reactor module (123) disposed inside the duct case (121).

12. The outdoor unit of an air conditioner of any one of claims 8 to 11, wherein a width or flow cross-sectional area of the duct case (121) is smaller than the width or the flow cross-sectional area of the box case (111).

13. The outdoor unit of an air conditioner of any one of claims 1 to 12, further comprising:
a heat dissipation cover (130) connected to one side of the heat dissipation duct (120) and guiding the air passing through the heat dissipation duct (120) to the heat exchange space (10a).

14. The outdoor unit of an air conditioner of claim 13,
wherein the heat dissipation cover (130) includes a cover outlet (132) through which air introduced into the heat dissipation cover (130) is discharged to the heat exchange space (10a), and
wherein the cover outlet (132) is disposed at a point lower than the duct outlet (121c).

15. The outdoor unit of an air conditioner of claim 13 or 14, wherein the heat dissipation cover (130) includes:
a lower surface portion forming the bottom surface;
side surface portions forming both side surfaces;
an upper surface portion forming an upper surface; and
a rear surface portion forming a rear surface,
wherein the front surface of the heat dissipation cover (130) is open, and
wherein a side surface portion of the heat dissipation cover (130) is coupled to a side surface portion of the heat dissipation duct (120) adjacent to a rear surface portion of the heat dissipation duct (120).

## Patentansprüche

1. Außeneinheit (10) einer Klimaanlage, umfassend:
ein Gehäuse, das einen Außenlufteinlass bildet;
eine Trennwand (19), die das Innere des Gehäuses in einen Wärmeaustauschraum (10a) und einen Elektro-Raum (10b) unterteilt;
einen in dem Elektro-Raum (10b) angeordneten Kompressor (20); und
eine in dem Elektro-Raum (10b) angeordnete Steuerkastenanordnung (100),
wobei die Steuerkastenanordnung (100) umfasst:
einen Steuerkasten (110), der mit dem Außenlufteinlass verbunden ist und in seinem Inneren angeordnete elektrische Komponenten aufweist; und
einen Wärmeableitungskanal (120), der mit einem Innenraum des Steuerkastens (110) verbunden ist und sich von einer Seite des Steuerkastens (110) zur Trennwand (19) erstreckt, und
wobei die durch den Außenlufteinlass eingeleitete Luft nach dem Durchströmen des Steuerkastens (110) und des Wärmeableitungskanals (120) an den Wärmeaustauschraum (10a) ausgeleitet wird.

2. Außeneinheit einer Klimaanlage nach Anspruch 1, wobei der Steuerkasten (110) umfasst:
einen Gehäuseeinlass (111b), durch den Luft eingeleitet wird; und
einen Gehäuseauslass (111c), durch den Luft ausgeleitet wird, und
wobei der Außenlufteinlass und der Gehäuseeinlass (11lb) durch ein Luftrohr (23) verbunden sind.

3. Außeneinheit einer Klimaanlage nach Anspruch 2, wobei der Steuerkasten (110) umfasst:
ein Gehäuse (111) mit einer offenen Fläche, das einen Aufnahmeraum bildet, in dem die elektrischen Komponenten untergebracht sind; und
einen Gehäusedeckel (112), der mit der offenen Fläche des Gehäuses (111) verbunden ist, und
wobei der Gehäuseeinlass (111b) und der Gehäuseauslass (111c) in dem Gehäuse (111) ausgebildet sind.

4. Außeneinheit einer Klimaanlage nach Anspruch 3, wobei das Gehäuse (111) umfasst:
einen unteren Flächenabschnitt, der eine Unterseite bildet;
Seitenflächenabschnitte, welche die beiden Seitenflächen bilden;
einen Oberflächenabschnitt, der eine Oberseite bildet; und
einen hinteren Flächenabschnitt, der eine hintere Fläche bildet, und
wobei die Vorderseite des Gehäuses (111) offen ist und der hintere Flächenabschnitt des Gehäuses (111) der Trennwand (19) zugewandt ist.

5. Außeneinheit einer Klimaanlage nach Anspruch 4,
wobei der Gehäuseeinlass (111b) an dem unteren Oberflächenabschnitt des Gehäuses (111) ausgebildet ist, und
wobei der Gehäuseauslass (111c) an dem hinteren Oberflächenabschnitt des Gehäuses (111) ausgebildet ist.

6. Außeneinheit einer Klimaanlage gemäß Anspruch 4 oder 5, wobei der Steuerkasten (110) ferner umfasst:
ein erstes Leiterplattenmodul (113), das an dem hinteren Oberflächenabschnitt des Gehäuses (111) installiert ist; und
ein zweites Leiterplattenmodul (114), das von der Vorderseite des ersten Leiterplattenmoduls (113) beabstandet ist,
wobei das erste Leiterplattenmodul (113) eine Komponente mit hoher Wärmeentwicklung umfasst, und
wobei das zweite Leiterplattenmodul (114) eine Komponente mit geringer Wärmeentwicklung umfasst.

7. Außeneinheit einer Klimaanlage gemäß einem der Ansprüche 4 bis 6, wobei der Wärmeableitungskanal (120) mit dem hinteren Oberflächenabschnitt des Gehäuses (111) verbunden ist und mit dem Gehäuseauslass (111c) verbunden ist.

8. Außeneinheit einer Klimaanlage gemäß einem der Ansprüche 1 bis 7, wobei der Wärmeableitungskanal (120) umfasst:
ein Kanalgehäuse (121), bei dem zumindest eine Fläche offen ist; und
eine Kanalabdeckung (122), die mit der offenen Fläche des Kanalkastens (121) gekoppelt ist, und
wobei der Kanalkasten (121) einen Kanalauslass (121c) aufweist, durch den die in den Kanalkasten (121) eingeleitete Luft nach außen ausgeleitet wird.

9. Außeneinheit einer Klimaanlage nach Anspruch 8, wobei das Kanalkasten (121) umfasst:
einen unteren Flächenabschnitt, der die Unterseite bildet;
Seitenflächenabschnitte, die die beiden Seitenflächen bilden; und
einen hinteren Flächenabschnitt, der eine hintere Fläche bildet,
wobei eine Vorderfläche und eine Oberseite des Kanalgehäuses (121) offen sind und
wobei der Kanalauslass (121c) an einem hinteren Flächenabschnitt des Kanalgehäuses (121) ausgebildet ist.

10. Außeneinheit einer Klimaanlage nach Anspruch 9,
wobei die offene Vorderfläche des Kanalgehäuses (121) durch den hinteren Flächenabschnitt des Kastengehäuses (111) abgedeckt ist, und
wobei die offene Oberseite des Kanalkastens (121) durch die Kanalabdeckung (122) abgedeckt ist.

11. Außeneinheit einer Klimaanlage gemäß einem der Ansprüche 8 bis 10, wobei der Wärmeableitungskanal (120) ferner ein Reaktormodul (123) umfasst, das innerhalb des Kanalgehäuses (121) angeordnet ist.

12. Außeneinheit einer Klimaanlage nach einem der Ansprüche 8 bis 11, wobei eine Breite oder eine Strömungsquerschnittsfläche des Kanalgehäuses (121) kleiner ist als die Breite oder die Strömungsquerschnittsfläche des Kastengehäuses (111).

13. Außeneinheit einer Klimaanlage nach einem der Ansprüche 1 bis 12, die ferner umfasst:
eine Wärmeableitungsabdeckung (130), die mit einer Seite des Wärmeableitungskanals (120) verbunden ist und die durch den Wärmeableitungskanal (120) strömende Luft an den Wärmeaustauschraum (10a) leitet.

14. Außeneinheit einer Klimaanlage gemäß Anspruch 13,
wobei die Wärmeableitungsabdeckung (130) einen Abdeckungsauslass (132) aufweist, durch den die in die Wärmeableitungsabdeckung (130) eingeleitete Luft zum Wärmeaustauschraum (10a) ausgeleitet wird, und
wobei der Abdeckungsauslass (132) an einer Stelle angeordnet ist, die tiefer liegt als der Kanalauslass (121c).

15. Außeneinheit einer Klimaanlage nach Anspruch 13 oder 14, wobei die Wärmeableitungsabdeckung (130) umfasst:
einen unteren Flächenabschnitt, der die Unterseite bildet;
Seitenflächenabschnitte, die die beiden Seitenflächen bilden;
einen oberen Flächenabschnitt, der eine Oberseite bildet; und
einen hinteren Oberflächenabschnitt, der eine hintere Oberfläche bildet,
wobei die Vorderseite der Wärmeableitungsabdeckung (130) offen ist und
wobei ein Seitenflächenabschnitt der Wärmeableitungsabdeckung (130) mit einem Seitenflächenabschnitt des Wärmeableitungskanals (120) benachbart zu einem hinteren Flächenabschnitt des Wärmeableitungskanals (120) verbunden ist.

## Revendications

1. Unité extérieure (10) d'un climatiseur comprenant :
un boîtier formant entrée d'air extérieur ;
une barrière (19) cloisonnant un intérieur du boîtier en un espace d'échange de chaleur (10a) et en un espace électrique (10b) ;
un compresseur (20) disposé dans l'espace électrique (10b) ; et
un ensemble formant boîte de commande (100) disposé dans l'espace électrique (10b),
dans laquelle l'ensemble formant boîte de commande (100) comporte :
une boîte de commande (110) reliée à l'entrée d'air extérieur et présentant des composants électriques disposés à l'intérieur ; et
un conduit de dissipation de chaleur (120) relié à un intérieur de la boîte de commande (110) et s'étendant depuis un côté de la boîte de commande (110) à la barrière (19), et
dans laquelle l'air introduit par l'entrée d'air extérieur est évacué vers l'espace d'échange de chaleur (10a) après avoir traversé la boîte de commande (110) et le conduit de dissipation de chaleur (120).

2. Unité extérieure d'un climatiseur selon la revendication 1, dans laquelle la boîte de commande (110) comporte :
une entrée de boîtier (111b) à travers laquelle de l'air est introduit ; et
une sortie de boîtier (111c) à travers laquelle de l'air est évacué, et
dans laquelle l'entrée d'air extérieur et l'entrée de boîtier (111b) sont reliées par un tuyau d'air (23).

3. Unité extérieure d'un climatiseur selon la revendication 2, dans laquelle la boîte de commande (110) comporte :
un boîtier de boîte (111) présentant une surface ouverte et formant un espace de logement dans lequel les composants électriques sont logés ; et
un couvercle de boîte (112) couplé à la surface ouverte du boîtier de boîte (111), et
dans laquelle l'entrée de boîtier (111b) et la sortie de boîtier (111c) sont formées dans le boîtier de boîte (111).

4. Unité extérieure d'un climatiseur selon la revendication 3, dans laquelle le boîtier de boîte (111) comporte :
une partie de surface inférieure formant une surface inférieure ;
des parties de surface latérale formant les deux surfaces latérales ;
une partie de surface supérieure formant une surface supérieure ; et
une partie de surface arrière formant une surface arrière, et
dans laquelle la surface avant du boîtier de boîte (111) est ouverte, et la partie de surface arrière du boîtier de boîte (111) fait face à la barrière (19).

5. Unité extérieure d'un climatiseur selon la revendication 4,
dans laquelle l'entrée de boîtier (111b) est formée sur la partie de surface inférieure du boîtier de boîte (111), et
dans laquelle la sortie de boîtier (111c) est formée sur la partie de surface arrière du boîtier de boîte (111).

6. Unité extérieure d'un climatiseur selon la revendication 4 ou 5, dans laquelle la boîte de commande (110) comporte en outre :
un premier module PCB (113) installé sur la partie de surface arrière du boîtier de boîte (111) ; et
un deuxième module PCB (114) espacé de l'avant du premier module PCB (113),
dans laquelle le premier module PCB (113) comporte un composant à forte génération de chaleur, et
dans laquelle le deuxième module PCB (114) comporte un composant à faible génération de chaleur.

7. Unité extérieure d'un climatiseur selon l'une quelconque des revendications 4 à 6, dans laquelle le conduit de dissipation de chaleur (120) est couplé à la partie de surface arrière du boîtier de boîte (111) et est relié à la sortie de boîtier (111c).

8. Unité extérieure d'un climatiseur selon l'une quelconque des revendications 1 à 7, dans laquelle le conduit de dissipation de chaleur (120) comporte :
un boîtier de conduit (121), dans lequel au moins une surface est ouverte ; et
un couvercle de conduit (122) couplé à la surface ouverte du boîtier de conduit (121), et
dans laquelle le carter de conduit (121) comporte une sortie de conduit (121c), à travers laquelle l'air introduit dans le boîtier de conduit (121) est évacué vers l'extérieur.

9. Unité extérieure d'un climatiseur selon la revendication 8, dans laquelle le boîtier de conduit (121) comporte :
une partie de surface inférieure formant la surface inférieure ;
des parties de surface latérale formant les deux surfaces latérales ; et
une portion de surface arrière formant une surface arrière,
dans laquelle une surface avant et une surface supérieure du boîtier de conduit (121) sont ouvertes, et
dans laquelle la sortie de conduit (121c) est formée sur une partie de surface arrière du boîtier de conduit (121).

10. Unité extérieure d'un climatiseur selon la revendication 9,
dans laquelle la surface avant ouverte du boîtier de conduit (121) est couverte par la partie de surface arrière du boîtier de boîte (111), et
dans laquelle la surface supérieure ouverte du boîtier de conduit (121) est recouverte par le couvercle de conduit (122).

11. Unité extérieure d'un climatiseur selon l'une quelconque des revendications 8 à 10, dans laquelle le conduit de dissipation de chaleur (120) comporte en outre un module de réacteur (123) disposé à l'intérieur du boîtier de conduit (121).

12. Unité extérieure d'un climatiseur selon l'une quelconque des revendications 8 à 11, dans laquelle une largeur ou une surface de section transversale d'écoulement du boîtier de conduit (121) est inférieure à la largeur ou à la surface de section transversale d'écoulement du boîtier de boîte (111).

13. Unité extérieure d'un climatiseur selon l'une quelconque des revendications 1 à 12, comprenant en outre :
un couvercle de dissipation de chaleur (130) relié à un côté du conduit de dissipation de chaleur (120) et guidant l'air traversant le conduit de dissipation de chaleur (120) vers l'espace d'échange de chaleur (10a).

14. Unité extérieure d'un climatiseur selon la revendication 13,
dans laquelle le couvercle de dissipation de chaleur (130) comporte une sortie de couvercle (132) à travers laquelle l'air introduit dans le couvercle de dissipation de chaleur (130) est évacué vers l'espace d'échange de chaleur (10a), et
dans laquelle la sortie de couvercle (132) est disposée sur un point plus bas que la sortie de conduit (121c).

15. Unité extérieure d'un climatiseur selon la revendication 13 ou 14, dans laquelle le couvercle de dissipation de chaleur (130) comporte :
une partie de surface inférieure formant la surface inférieure ;
des parties de surface latérale formant les deux surfaces latérales ;
une partie de surface supérieure formant une surface supérieure ; et
une partie de surface arrière formant surface arrière,
dans laquelle la surface avant du couvercle de dissipation de chaleur (130) est ouverte, et
dans laquelle une partie de surface latérale du couvercle de dissipation de chaleur (130) est couplée à une partie de surface latérale du conduit de dissipation de chaleur (120) de manière adjacente à une partie de surface arrière du conduit de dissipation de chaleur (120).
